# EUROPÄISCHE PATENTSCHRIFT

(11) **EP 1 585 377 B1**
(45) Veröffentlichungstag und Bekanntmachung des Hinweises auf die Patenterteilung: **13.12.2006**
(21) Anmeldenummer: 05006076.3
(22) Anmeldetag: 19.03.2005
(51) Int. Cl.: H05K 5/00

(54) **Gehäuse, insbesondere aus Blech, und Verfahren zu seiner Herstellung**
Housing, in particular made of sheet metal, and manufacturing method thereof
Boîtier, préférentiellement constitué de tôle, et procédé pour sa fabrication

(30) Priorität: 08.04.2004 DE 102004018423
(43) Veröffentlichungstag der Anmeldung: 12.10.2005
(73) Patentinhaber: OBO Bettermann GmbH & Co. KG, 58710 Menden (DE)
(72) Erfinder: Herzig, Markus, 51643 Gummersbach (DE); Raschke, Jörg, 51674 Wiehl (DE)
(74) Vertreter: Patentanwälte Ruff, Wilhelm, Beier, Dauster & Partner

(56) Entgegenhaltungen:
- DE-A1- 3 328 242
- DE-A1- 3 346 243
- US-A- 5 419 629
- US-B1- 6 515 230

## Beschreibung

Die Erfindung betrifft ein Verfahren zum Herstellen von Gehäusen, bei dem zunächst flache Zuschnitte in der Form von Platinen, insbesondere aus Blech gestanzt und abschnittsweise um Kanten zu Seitenwänden hochgeklappt und zur Endform gebracht werden, wobei mindestens zwei im Winkel von vorzugsweise 90° zueinander verlaufende Eckseitenwände zur Stabilisierung des Gehäuses fest miteinander verbunden werden. Die Erfindung betrifft auch ein Blechgehäuse, das nach einem solchen Verfahren hergestellt ist.

Ein Verfahren der eingangs genannten Art wird zur Herstellung von Blechgehäusen, deren seitliche Umkantungen auf Zug oder Druck beansprucht werden, in der Praxis benutzt. Dabei werden die Eckseitenwände in ihren Eckbereichen zur Erzielung einer ausreichenden Stabilität des Gehäuses punktgeschweißt. Dies ist ein sehr aufwändiger und teurer Arbeitsvorgang, der stets zusätzlich zu dem Umkantungsverfahren vorgenommen werden muss.

Der Erfindung liegt die Aufgabe zugrunde, nach einer vereinfachten Herstellungsmethode für solche vorwiegend aus Blech hergestellte Gehäuse zu suchen, wie sie beispielsweise für die Aufnahme und Unterbringung elektrotechnischer Installationen oder dergleichen gebraucht werden und in allgemeiner Art, auch bezüglich ihres Herstellungsverfahrens, aus der DE 33 25 360 C2 oder der DE 195 01 340 C1 bekannt sind. Dabei wird im ersten Fall der DE 33 25 360 C2 dafür gesorgt, dass Knickdurchbrüche so ausgebildet werden, dass eine geradlinige Stanzkante und eine Bogenkante gebildet werden. Im zweiten Fall der DE 195 01 340 C1 wird ein Gehäusedeckel über einen Scharnierbereich schwenkbar angeordnet, der durch mehrere nebeneinanderliegende Längsschlitze gebildet wird, die zwischen sich elastisch biegsame Stege belassen. Eine Eckverstärkung liegt in beiden Fällen nicht vor.

Der relevante Stand der Technik schließt Dokument US 5 419 629 A ein.

Zur Lösung der vorher genannten Aufgabe nach einer Vereinfachung des Herstellungsverfahrens für solche insbesondere aus Blech bestehenden Gehäuse zu suchen, wird mit der Erfindung bei einem Verfahren der eingangs genannten Art vorgeschlagen, dass die Platinen in den Abschnitten, welche die Eckseitenwände bilden, mit Ausstanzungen und Ausprägungen versehen werden, die beim Hochklappen formschlüssig rastend ineinander greifen und eine feste Verbindung gewährleisten.

Durch diese Ausgestaltung wird ein zusätzlicher Arbeitsgang, wie beispielsweise ein Punktverschweißen in den Eckbereichen, überflüssig. Die Ecken werden bereits bei dem ohnehin notwendigen Aufkant- und Biegevorgang ausreichend formschlüssig versteift.

In Weiterbildung der Erfindung kann die Ausstanzung und die Ausprägung im Abschnitt der ersten Eckseitenwand als eine Öffnung und eine diese zumindest teilweise überdeckende Lasche ausgebildet sein, die eine Einführung für die zweite Eckseitenwand bildet und die Gewähr dafür gibt, dass diese zweite Eckseitenwand beim Hochbiegevorgang auch zwangsläufig so geführt wird, dass die gewünschte formschlüssige Verrastung eintritt.

Im Abschnitt der zweiten Eckseitenwand kann dabei ein entgegen der Klapprichtung aus der Wandung des Platinenabschnittes abstehender Rasthaken angebracht werden, der sich nach dem Hochklappen in der Endlage in der Öffnung der ersten Seitenwand verhakt.

In Weiterbildung der Erfindung kann die Lasche der ersten Eckseitenwand einseitig aus dem Material der Platine herausgestanzt und mindestens in einem Bereich in einem Abstand vor der dadurch gebildeten Öffnung verlaufen, der in etwa der Materialstärke der Platine entspricht. Diese Ausgestaltung sichert das enge Aneinanderliegen der Eckseitenwände und den dort erwünschten Formschluss zu.

In Weiterbildung der Erfindung kann der Rasthaken aus einer unter einem Winkel zur Platinenfläche verlaufenden Zunge bestehen, die in weiterer Ausgestaltung durch dreiseitige Einschnitte und durch Abbiegen um die mit dem Platinenmaterial verbundene Seite gebildet wird.

Das durch ein solches Herstellungsverfahren gebildete Gehäuse, insbesondere aus Blech, ist durch eine dauerhafte Verrastung der aneinanderliegenden Eckseitenwände gekennzeichnet, die zumindest in einem Eckbereich vorliegt, natürlich auch in allen Eckbereichen vorgesehen werden kann.

Die Erfindung ist anhand eines Ausführungsbeispieles in den nachfolgenden Zeichnungen dargestellt und wird im folgenden beschrieben. Es zeigen:
- Fig. 1: die Darstellung eines Eckbereiches einer vorgestanzten Blechplatine zur Herstellung eines Blechgehäuses für die Aufnahme elektrotechnischer Installationen,
- Fig. 2: die vergrößerte und um 180° gewendete Darstellung des Eckbereiches der Platine der Fig. 1 mit den für die Verrastung vorgesehenen Elementen,
- Fig. 3: die perspektivische Darstellung des Eckbereiches mit den hochgekanteten und später zur Anlage kommenden Eckseitenwänden,
- Fig. 4: die perspektivische und vergrößerte Darstellung des Schnittes nach der Schnittlinie IV-IV der Fig. 3 nach dem Zusammenführen der Eckseitenwände und
- Fig. 5: die perspektivische Darstellung des fertiggestellten und formfest ineinander verrasteten Eckbereiches des Blechgehäuses.

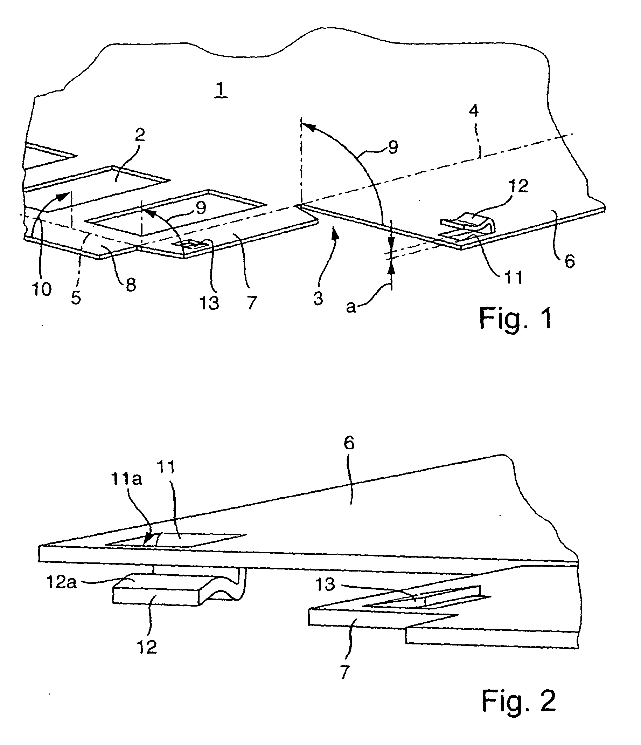

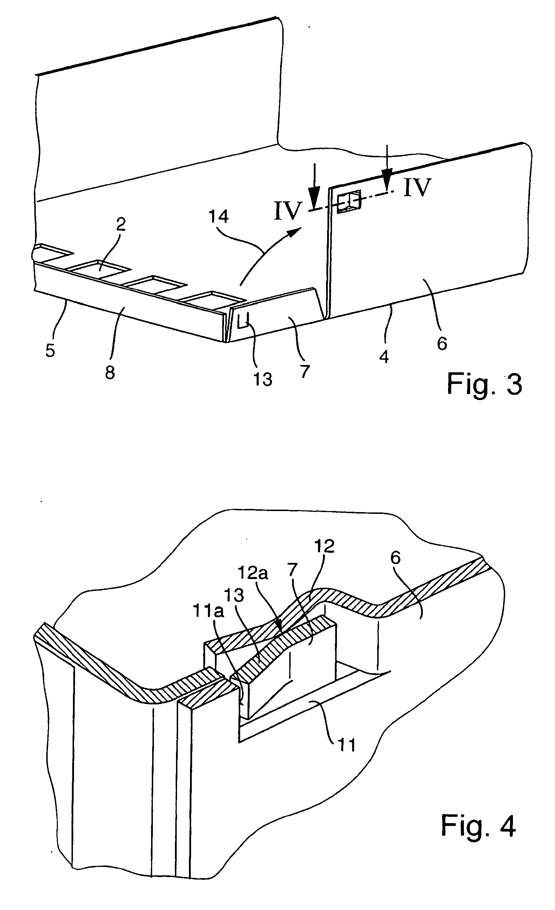

Die Fig. 1 zeigt eine Blechplatine 1, die mit Ausnehmungen 2 und mit einer Ausstanzung 3 in dem gezeigten, später zu einer Gehäuseecke werdenden Eckbereich versehen ist. Die Platine 1 ist, wie strichpunktiert angedeutet ist, mit Knickkanten 4 bzw. 5 versehen, um welche die Platinenabschnitte 6, 7 bzw. 8 jeweils im Sinn der Pfeile 9 bzw. 10 um jeweils 90° in die aus Fig. 3 ersichtliche Form hochgeklappt werden.

Der Seitenwandabschnitt 6 besitzt dabei in seinem späteren mit dem Wandabschnitt 7 in Berührung kommenden Eckbereich eine Öffnung 11, die beim Ausführungsbeispiel rechteckig ist und durch eine an drei Seiten aus dem Material des Abschnittes 6 herausgeschnittene und hochgedrückte Lasche 12 überdeckt wird. Die Lasche 12 ist dabei so ausgebildet, dass sie zumindest in einem Bereich 12a einen Abstand a zur Oberfläche des Abschnittes 6 bildet, welcher der Materialstärke der Platine 1 entspricht.

Der Abschnitt 7 ist in dem Bereich, der später an der Stelle der Lasche 12 zu liegen kommt, mit einer Zunge 13 versehen, die durch dreiseitige Einschnitte und durch Abbiegen um die mit dem Platinenmaterial verbundene Seite gebildet ist und einen unter einem Winkel zur Platinenfläche abgebogenen Rasthaken bildet. Die Fig. 3 macht dabei deutlich, dass der hochgebogene Abschnitt 7 mit dem gegen die Klapprichtung des Pfeiles 14 abgebogenen zungenartigen Rasthaken 13 beim Hochbiegen im Sinn des Pfeiles 14 an der Innenseite des Wandabschnittes 6 entlanggeführt wird und in die von der Lasche 12 gebildete Führung mit dem Abstand a hereingeführt wird. Erreicht der Abschnitt 7 dabei nach der 90°-Hochkantung die Endstellung, so rastet die frei abstehende Kante der Zunge 13, die ebenso wie die Lasche 12 beim Einführgang unter elastischer Verformung stand, in die Öffnung 11 ein und sichert formschlüssig die erzielte Eckverbindung auch dann, wenn die von den Abschnitten 6 und 7 gebildeten Eckseitenwände auf Zug oder Druck beansprucht werden. Das abstehende Ende der Zunge 13 liegt dann an der Kante 11 a der Öffnung 11 an, wie auch aus Fig. 2 hervorgeht. Die Fig. 4 macht dabei deutlich, dass in diesem Endzustand die Lasche 12, die vorher für das exakte Einführen des Abschnittes 7 und der Zunge 13 gesorgt hat, den Wandteil 7 fest gegen den äußeren Wandteil 6 drückt und dabei auch dafür sorgt, dass die Zunge 13 mit ihrem abstehenden Ende an der Kante 11a der Öffnung 11 zur Anlage kommt.

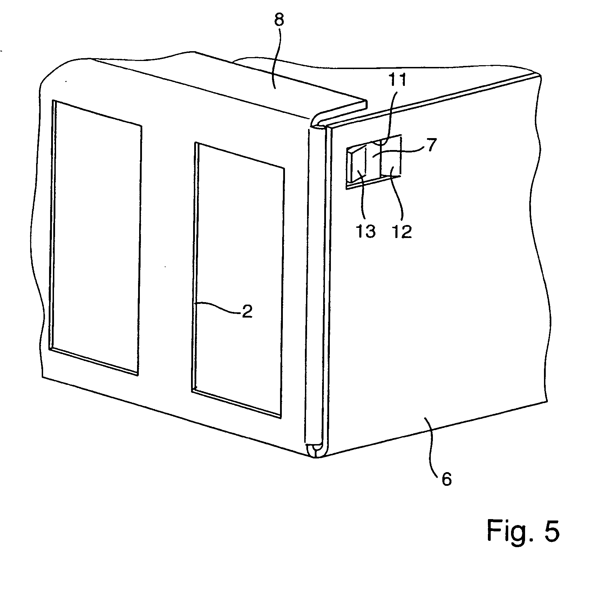

Die Fig. 5 zeigt die Endform des Blechgehäuses, dessen Eckbereich durch den erzielten Formschluss der Eckseitenwände 6 und 7 ausreichende Stabilität aufweist, ohne dass ein gesonderter Arbeitsvorgang für die stabile Verbindung dieser Eckseitenwände 6 und 7 notwendig gewesen ist.

Es ist selbstverständlich möglich, zwei oder auch mehr Eckbereiche eines Blechgehäuses auf die gezeigte Weise zu verstärken und formschlüssig aneinander zu halten. Anhand der Zeichnungen wurde lediglich versucht, die Art des formschlüssigen Ineinandergreifens der Eckbereiche anhand eines Platineneckbereiches zu zeigen.

## Patentansprüche

1. Verfahren zum Herstellen von Gehäusen, bei dem zunächst flache Zuschnitte in der Form von Platinen (1), insbesondere aus Blech gestanzt und abschnittsweise um Kanten zu Seitenwänden (6, 7) hochgeklappt und zur Endform gebracht werden, wobei mindestens zwei im Winkel von vorzugsweise 90° zueinander verlaufende Eckseitenwände zur Stabilisierung des Gehäuses fest miteinander verbunden werden, **dadurch gekennzeichnet, dass** die Platinen (1) in den Abschnitten (6, 7), welche die Eckseitenwände bilden, mit Ausstanzungen (11) und Ausprägungen (12, 13) versehen werden, die beim Hochklappen formschlüssig rastend ineinander greifen und die feste Verbindung gewährleisten.

2. Verfahren nach Anspruch 1, **dadurch gekennzeichnet, dass** die Ausstanzung und Ausprägung im Abschnitt (6) der ersten Eckseitenwand als eine Öffnung (11) und eine diese zumindest teilweise überdeckende Lasche (12) ausgebildet sind, die eine Einführung für die zweite Eckseitenwand (7) bildet.

3. Verfahren nach Anspruch 2, **dadurch gekennzeichnet, dass** im Abschnitt (7) der zweiten Eckwand ein entgegen der Klapprichtung (14) aus der Wandung des Platinenabschnittes (1) abstehender Rasthaken (13) angebracht wird, der sich nach dem Hochklappen in der Endlage in der Öffnung (11) der ersten Eckseitenwand (6) verhakt.

4. Verfahren nach Anspruch 2 oder 3, **dadurch gekennzeichnet, dass** die Lasche (12) der ersten Eckseitenwand (6) einseitig aus dem Material der Platine (1) herausgestanzt und mindestens in einem Bereich (12a) in einem Abstand (a) vor der dadurch gebildeten Öffnung (11) verläuft, der in etwa der Materialstärke der Platine (1) entspricht.

5. Verfahren nach Anspruch 3, **dadurch gekennzeichnet, dass** der Rasthaken aus einer unter einem Winkel zur Platinenfläche verlaufenden Zunge (13) besteht.

6. Verfahren nach Anspruch 5, **dadurch gekennzeichnet, dass** die Zunge (13) durch dreiseitige Einschnitte und durch Abbiegen um die mit dem Platinenmaterial verbundene Seite gebildet wird.

7. Gehäuse, insbesondere aus Blech, das nach dem Verfahren nach Anspruch 1 hergesellt ist und zumindest in einem Eckbereich mit einer dauerhaften Verrastung der aneinanderliegenden Eckseitenwände (6, 7) versehen ist.

## Claims

1. Method for manufacturing housings, in which method first of all flat blanks in the form of plates (1), especially of sheet-metal, are stamped out and folded upwards in portions about edges to form side walls (6, 7) and are brought into the final form, at least two corner side walls which extend at an angle of preferably 90° to each other being connected securely to each other in order to stabilise the housing, **characterised in that** the plates (1) are, in the portions (6, 7) forming the corner side walls, provided with stamped-out portions (11) and raised portions (12, 13) which engage in one another in a positive-locking manner when folding upwards takes place and ensure a secure connection.

2. Method according to claim 1, **characterised in that** the stamped-out portion and the raised portion in the portion (6) of the first corner side wall are in the form of an opening (11) and a tab (12) which overlaps the opening (11) at least partially and which forms a lead-in for the second corner side wall (7).

3. Method according to claim 2, **characterised in that** a locking barb (13) projecting from the wall of the plate portion (1) counter to the folding direction (14) is fitted in the portion (7) of the second corner wall and, after folding upwards has taken place, catches, in the end position, in the opening (11) of the first corner side wall (6).

4. Method according to claim 2 or 3, **characterised in that** the tab (12) of the first corner side wall (6) is stamped out on one side from the material of the plate (1) and extends in at least one region (12a) at a distance (a) in front of the opening (11) formed thereby, which distance corresponds approximately to the thickness of the material of the plate (1).

5. Method according to claim 3, **characterised in that** the locking barb comprises a tongue (13) which extends at an angle to the face of the plate.

6. Method according to claim 5, **characterised in that** the tongue (13) is formed by incisions on three sides and by bending about the side connected to the material of the plate.

7. Housing, especially of sheet-metal, which is manufactured in accordance with the method according to claim 1 and which, in at least one corner region, is provided with a permanent locking of the mutually abutting corner side walls (6, 7).

## Revendications

1. Procédé pour la fabrication de boîtiers, pour laquelle sont découpées dans un premier temps des sections plates en forme de plaques (1), en particulier en tôle, en partie relevées le long de bords pour former des parois latérales (6, 7), et portées dans leur forme finale, sachant qu'au moins deux parois latérales d'angles, s'étendant l'une par rapport à l'autre à un angle de préférence de 90°, sont fixement reliées l'une à l'autre pour stabiliser le boîtier, **caractérisé en ce que** les plaques (1) sont, dans les sections (6, 7) formant les parois latérales d'angle, pourvues d'ouvertures découpées (11) et de parties en saillie (12, 13) qui, lors du rabattement, s'enclenchent de façon mécanique l'une dans l'autre et garantissent une solide fixation.

2. Procédé selon la revendication 1, **caractérisé en ce que** la partie découpée et la partie en saillie dans la section (6) de la première paroi latérale d'angle sont conçues comme une ouverture (11) et une patte (12) recouvrant en superposition au moins en partie l'ouverture et formant un logement pour la seconde paroi latérale d'angle (7).

3. Procédé selon la revendication 2, **caractérisé en ce que** dans la section (7) de la seconde paroi d'angle est disposé un fermoir (13) dépassant de la paroi de la section de plaque (1) dans le sens opposé au sens de rabattement (14), lequel s'enclenche en position finale dans l'ouverture (11) de la première paroi latérale d'angle (6) après le rabattement.

4. Procédé selon la revendication 2 ou 3, **caractérisé en ce que** la patte (12) de la première paroi latérale d'angle (6) est découpée dans le matériau de la plaque (1), se trouve en saillie sur un côté et s'étend à une distance (a) au moins dans une zone (12a) devant l'ouverture (11) ainsi formée, zone correspondant approximativement à l'épaisseur du matériau de la plaque (1).

5. Procédé selon la revendication 3, **caractérisé en ce que** le fermoir est constitué d'une languette (13) s'étendant en faisant un angle par rapport à la surface de la plaque.

6. Procédé selon la revendication 5, **caractérisé en ce que** la languette (13) est formée par découpage trilatéral et pliage le long du côté relié au matériau de la plaque.

7. Boîtier, en particulier en tôle, fabriqué d'après le procédé selon la revendication 1 et pourvu au moins dans une section d'angle d'un dispositif d'enclenchement durable des parois latérales d'angle (6, 7) appliquées l'une contre l'autre.
